# EUROPÄISCHE PATENTANMELDUNG

(11) **EP 0 694 926 A1**
(43) Veröffentlichungstag der Anmeldung: **31.01.1996**
(21) Anmeldenummer: 95109892.0
(22) Anmeldetag: 24.06.1995
(51) Int. Cl.: H01B 1/12, H05K 9/00

(54) **Elektrisch leitfähiger Glasfaser-Verbundwerkstoff**

(30) Priorität: 29.07.1994 DE 4426906
(71) Anmelder: Daimler-Benz Aerospace Airbus Gesellschaft mit beschränkter Haftung, D-21129 Hamburg (DE)
(72) Erfinder: Wentzel, Hans-Peter, D-27305 Bruchhausen-Vilsen (DE); Schüler, Rüdiger, D-20535 Hamburg (DE); Petermann, Jürgen, D-44227 Dortmund (DE)
(74) Vertreter: Hansmann, Dierk, Dipl.-Ing.

(57) **Zusammenfassung**

Der Verbundwerkstoff besteht aus Kunststoff, der im wesentlichen aus einem faserverstärkten Duromer ausgebildet ist. Das Duromer ist mit einer elektrisch leitfähigen Substanz kombiniert. Das Duromer ist als polymere Matrixstruktur ausgebildet, in die die elektrisch leitfähige Substanz als feindisperser Füllstoff eingebettet ist. Insbesondere ist als Füllstoff ein Agglomerat aus Rußteilchen zweckmäßig.

## Beschreibung

Die Erfindung betrifft Verbundwerkstoff aus Kunststoff, der mindestens teilweise aus einem faserverstärkten Duromer ausgebildet ist und der mit einem elektrisch leitfähigen Substrat kombiniert ist und bei dem das Duromer als polymere Matrixanordnung ausgebildet ist, in die die elektrisch leitfähige Substanz als Füllstoff eingebettet ist und bei dem der Füllstoff aus Ruß ausgebildet ist.

Die Erfindung betrifft darüber hinaus ein verfahren zur Herstellung des Verbundwerkstoffes.

Aus faserverstärkten Duromeren ausgebildete Verbundwerkstoffe werden insbesondere im Flugzeugbau eingesetzt. Aufgrund ihrer physikalischen Eigenschaften sind diese Verbundwerkstoff elektrisch isolierend und werden für Verkleidungen und Abdeckungen verwendet. Aufgrund der elektrisch nichtleitenden Eigenschaften ist bauartbedingt kein Abschirmvermögen gegen elektrische Felder und elektromagnetische Wellen vorhanden. Darüber hinaus ist es nicht möglich, eine Ableitung elektrostatischer Aufladungen durchzuführen. Diese mangelnde Ableitung elektrostatischer Aufladungen kann Fehlfunktionen einer eingesetzten Bordelektronik sowie Störungen im Funkverkehr zur Folge haben.

Zur Vermeidung dieser nachteiligen Eigenschaften ist es bereits bekannt, auf den Verbundwerkstoff ein metallisches Gewebe oder eine metallische Folie aufzubringen. Darüber hinaus können Antistatiklacke oder Leitlacke verwendet werden. Diese zusätzlichen Beschichtungen haben jedoch zum einen erhöhte Kosten und ein erhöhtes Gewicht zur Folge, darüber hinaus unterliegen Lackschichten einem Alterungsprozeß und müssen in bestimmten Zeitintervallen erneuert werden.

Aus der Veröffentlichung CPI-Profile Booklet 1988, 88-234184/34 zu JP 63 172 722 A ist ein elektrisch leitfähiger Epoxydharzkleber bekannt. Es ist eine Mischung von 100 Gewichtsteilen Epoxydharz, 10 bis 200 Gewichtsteilen Kohlenstoffasern und 5 bis 100 Gewichtsteilen Leitfähigkeitsruß vorgesehen. Bezogen auf das Endprodukt werden somit circa 13 Gewichtsprozente bis 75 Gewichtsprozente an leitfähigen Füllstoffen verwendet.

In der EP 232 503 A2 wird ein weiterer Verbundwerkstoff beschrieben. Es wird ein Duromer beschrieben, das ein Polyester- oder Epoxydharz mit 15 bis 23 Gewichtsprozenten enthält. Zusätzlich ist ein inerter Füllstoff mit 80 bis 52 Gewichtsprozenten und ein Faseranteil mit 5 bis 25 Gewichtsprozenten vorgesehen. Die Fasern können aus Glasfasern, Polyesterfasern oder Polyamidfasern ausgebildet sein. Es sind somit keine die Leitfähigkeit erhöhenden Füllstoffe vorgesehen.

Aufgabe der vorliegenden Erfindung ist es daher, einen Verbundwerkstoff der einleitend genannten Art derart auszubilden, daß eine hohe Alterungsbeständigkeit gegeben ist und eine preiswerte Fertigung ermöglicht wird.

Diese Aufgabe wird erfindungsgemäß dadurch gelöst, daß ein Anteil des Füllstoffes von 0,1 - 2,0 Gew-% vorgesehen ist, daß der Füllstoff feindispers mit einer Teilchengröße < 30 µm eingebracht ist und daß zur Erhöhung der Ionenkonzentration ein Salz enthalten ist.

Durch die Einbettung der elektrisch leitfähigen Substanz in die Matrixstruktur des Duromers wird ein fester Verbund aus elektrisch leitfähigen und elektrisch nichtleitfähigen Komponenten bereitgestellt, dessen geometrische Anordnung nicht durch Alterungseinflüsse gestört wird. Der Verbundwerkstoff ist in einem Arbeitsgang herstellbar, so daß eine nachgeschaltete Bearbeitung entfällt. Dies führt zu geringen Herstellungskosten.

Die Faserverstärkung des Duromers kann dadurch erfolgen, daß die Faserverstärkung aus Glasfasern ausgebildet ist.

Alternativ oder ergänzend ist es aber auch möglich, daß die Faserverstärkung aus Aramidfasern ausgebildet ist.

Eine ausreichende Dispersion erfolgt beispielsweise bei geringen Mengen dadurch, daß der Füllstoff für etwa eine Stunde bei einer Mischerdrehzahl von 5.500 U/min in ein zur Ausbildung des Duromers vorgesehenes Harz dispergiert wird.

Für die Materialeigenschaften ist es insbesondere zweckmäßig, daß der Dispergierungsvorgang solange durchgeführt wird, bis eine Teilchengröße des Füllstoffes von höchstens 1 µm erreicht ist.

Zur Unterstützung des Agglomerationsvorganges wird vorgeschlagen, daß nach der Durchführung des Dispergierungsvorganges eine Ruhephase von zwei bis sechs Tagen vorgesehen ist.

Die Temperierung bei der Durchführung des Agglomerationsvorganges kann dadurch vereinfacht werden, daß die Ruhephase bei Raumtemperatur durchgeführt wird.

Zur Unterstützung einer Verteilung eines Härters innerhalb des zur Herstellung des Duromers vorgesehenen Harzes wird vorgeschlagen, daß ein Einrühren eines Härters in die aus dem Harz und dem Füllstoff gebildete Dispersion bei einer verringerten Viskosität des Harzes, welche durch eine Temperaturerhöhung erreicht wird, durchgeführt wird.

Zur Kompensation von abstoßenden Kräften durch elektrische Aufladung der Füllstoffpartikel, welche den Agglomerierungs-Vorgang behindern, wird vorgeschlagen, daß die Dispersion mit einem Zusatz eines Salzes versehen wird.

Eine zweckmäßige Materialauswahl besteht darin, daß Kupferchlorid als Salz zugegeben wird.

In Abhängigkeit vom Gehalt an Füllstoff ist es zweckmäßig, daß Kupferchlorid in einer Menge von 0,001 - 0,10 Gew-% zugegeben wird.

In der Zeichnung sind Ausführungsbeispiele der Erfindung schematisch dargestellt. Es zeigen:
- Fig. 1: eine Darstellung eines Flugzeuges mit typischen Einsatzregionen für den Verbundwerkstoff,
- Fig. 2: einen Querschnitt durch den Verbundwerkstoff,
- Fig. 3: ein Diagramm zur Veranschaulichung des spezifischen Widerstandes des Matrixstems (Duromers) in Abhängigkeit von einem Gehalt an Ruß,
- Fig. 4: ein Diagramm zur Veranschaulichung von Widerstandswerten in Abhängigkeit vom Rußgehalt,
- Fig. 5: ein Ablaufdiagramm zur Veranschaulichung einer Bildung von Agglomeraten aus Primärteilchen,
- Fig. 6: ein Diagramm zur Veranschaulichung von Werten des E-Moduls in Abhängigkeit vom Rußgehalt,
- Fig. 7: ein Diagramm zur Veranschaulichung der Bruchdehnung in Abhängigkeit vom Rußgehalt
**und**
- Fig. 8: ein Diagramm zur Veranschaulichung der Zugfestigkeit in Abhängigkeit vom Rußgehalt.

Im Bereich eines Flugzeuges (1) kann der Verbundwerkstoff beispielsweise als Endkappe (2) eines Seitenleitwerkes, als Endkastendeckel(3) des Seitenleitwerkes oder als Vorderkante (4) des Seitenleitwerkes eingesetzt sein. Eine weitere Verwendung ist im Bereich von Verkleidungen (5) der Landeklappen oder von Verkleidungen (6) im Übergangsbereich eines Flügels (7) in einen Rumpf (8) des Flugzeuges (1) möglich. Schließlich ist es auch möglich, einen Einsatz im Bereich einer Verkleidung (9) eines Triebwerkes oder im Bereich einer Flugzeugnase (10) (Radom) vorzunehmen.

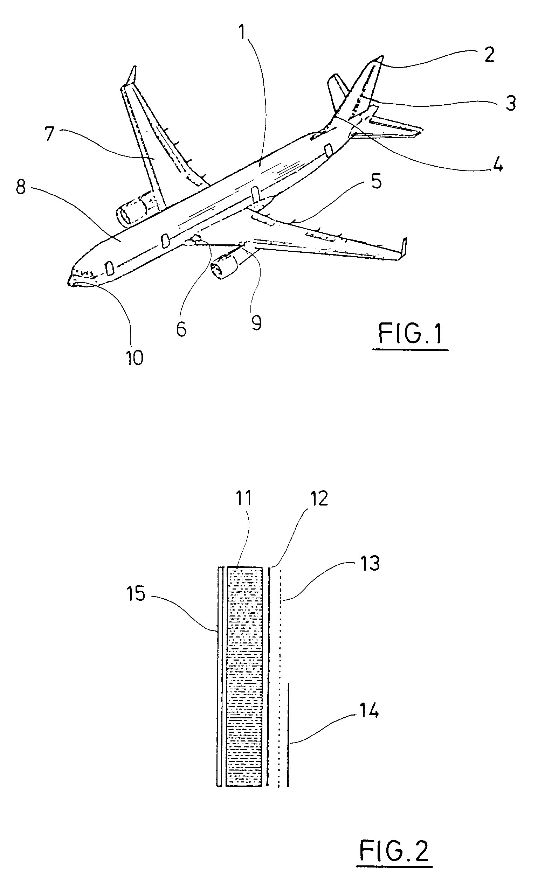

Ein Bauteil unter Verwendung des Verbundwerkstoffes kann entsprechend der Ausführungsform in Fig. 2 derart ausgebildet sein, daß auf einer Wabe (11) eine Abdeckplatte (12) angeordnet ist, die aus dem Verbundwerkstoff ausgebildet ist. Die Abdeckplatte (12) kann im Bereich ihre der Wabe (11) abgewandten Ausdehnung mit einem Primer (13) versehen sein, auf den ein Decklack (14) aufgetragen ist. Auf einer der Abdeckplatte (12) abgewandten Seite der Wabe (11) ist eine Schutzplatte (15) angeordnet.

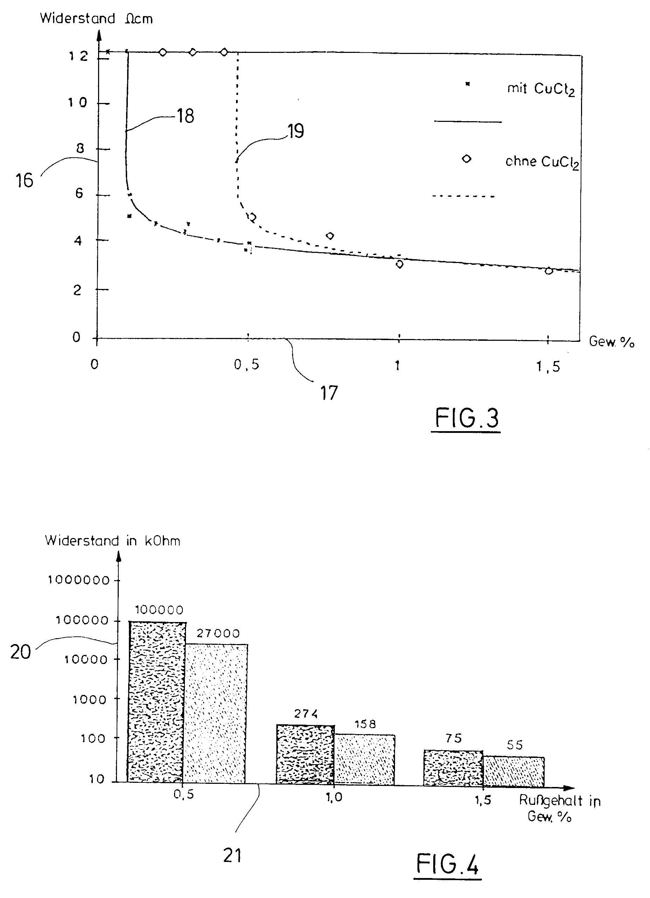

Fig. 3 zeigt ein Diagramm, bei dem entlang einer Achse (16) der Logarithmus des spezifischen Widerstandes in Ohm-cm und entlang einer Achse (17) ein Rußgehalt im Matrixsystem in Gew-% aufgetragen ist. Ein Verlauf (18) zeigt den spezifischen Widerstand bei einem zusätzlich eingebrachten Anteil von Kupferchlorid und in einem Verlauf (19) ist der spezifische Widerstand ohne eine derartige Einbringung von Kupferchlorid veranschaulicht. Für den Verlauf (18) ist ein Anteil von 0,04 Gew-% an Kupferchlorid vorgesehen. Durch die Zugabe des Kupferchlorides wird die Perkolationsschwelle von ca. 0,5 Gew-% auf unter 0,1 Gew-% verringert. Alle Angaben in Gew-% beziehen sich auf das Matrixsystem beziehungsweise das Duromer.

Bei einer Ausbildung des Verbundwerkstoffes aus rußgefülltem und glasfaserverstärktem Epoxydharz mit einem Fasergehalt von etwa 60 Vol-% ergibt sich ein Oberflächenwiderstand in Abhängigkeit vom Rußgehalt im Matrixsystem entsprechend Fig. 4. Entlang einer Achse (20) ist der Widerstand in kOhm und entlang einer Achse (21) ein Rußgehalt in Gew-% aufgetragen. Die dunkel schraffierten Blöcke geben den Widerstand senkrecht zu einem Faserverlauf und die hell schraffierten Blöcke den Widerstand bei einer Messung im wesentlichen parallel zur Faserlängsrichtung wider.

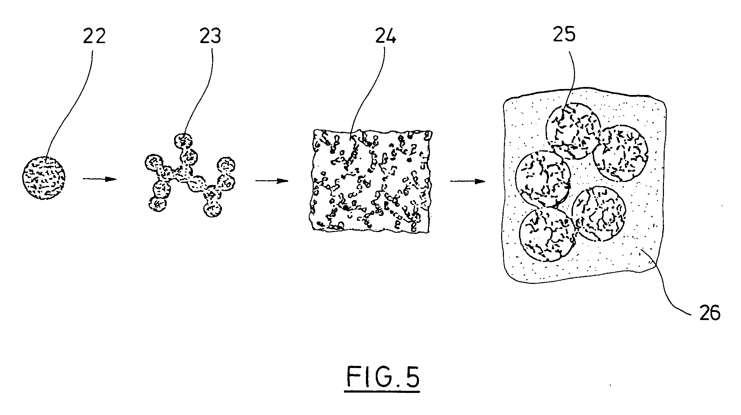

Zur Füllung des Duroplastes wird Ruß in einer speziellen Gestaltung verwendet. Den Aufbau dieser Teilchen zeigt Fig. 5. Ausgangsstoff sind Primärteilchen (22), die einen Durchmesser von etwa 30 µm aufweisen. Aus den Primärteilchen wird dann in einem ersten Schritt ein Aggregat (23) gebildet, das durch einen kettenartigen und verzweigten Aufbau einer Aneinanderreihung einer Vielzahl von etwa kugelförmigen Primärteilchen (22) realisiert ist. Aus den Aggregaten (23) entsteht eine dichte Packung (24), die durch einen Agglomerationsvorgang ein Agglomerat (25) ausbildet, das aus leitfähigen Packungen (24) von Aggregat (23) ausgebildet ist. Jeweils entstehende Hohlräume sind von den Duroplasten (26) gefüllt.

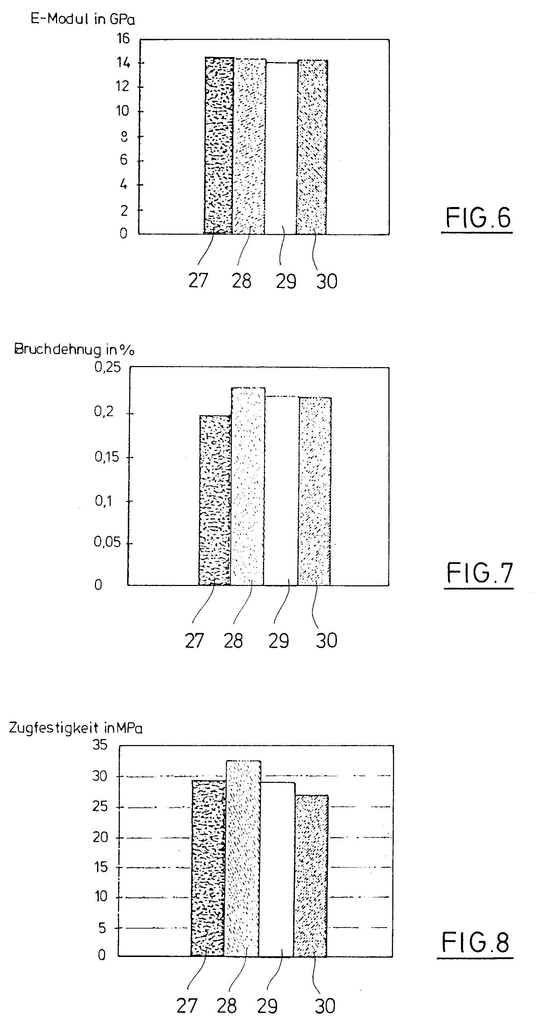

Zur weiteren Veranschaulichung der physikalischen Eigenschaften des Verbundwerkstoffes dienen die Figuren 6 bis 8. Für ein rußgefülltes glasfaserverstärktes Epoxydharz mit einem Fasergehalt von 60 Vol-% ergeben sich die dargestellten Daten aus einem Querzugsversuch bei Raumtemperatur. Es wurden E-Glasfasern Roving K43 von Gewetex verwendet. Die Glasfaser wird durch die Bezeichnung 1200 Tex, Aminosilanschlichte weiter definiert. Als Epoxydharz wird Araldit LY 566/HY 932 verwendet. Als Ruß dient Printex XE2. Die Aushärtung wurde innerhalb eines Zeitraumes von drei Stunden bei einer Temperatur von 80° C und einer anschließenden Zeitdauer von acht Stunden bei 140° C durchgeführt. Die Probengeometrie weist eine Länge von > = 165 mm auf, die Breite beträgt 25,3 bis 26,5 mm und die Tiefe 1,42 mm. Es sind acht Lagen vorgesehen. Die Zugversuche wurden nach ASTM-Norm D 3039 durchgeführt.

In Fig. 6 ist das E-Modul in Giga-Pascal aufgetragen. Eine Probe (27) weist einen Rußgehalt von 0,0 Gew-% auf, eine Probe (28) ist mit einem Rußgehalt im Harz von 0,5 Gew-%, eine Probe (29) mit einem Rußgehalt von 1,0 Gew-% und eine Probe (30) mit einem Rußgehalt von 1,5 Gew-% versehen. In Fig. 7 ist für die Proben (27,28,29,30) die Zugfestigkeit in Mega-Pascal und in Fig. 8 die Bruchdehnung in % dokumentiert.

Als Duromere für den Verbundwerkstoff können außer den bereits erwähnten Epoxydharzen auch Polyesterharze, ungesättigte Polyesterharze und Phenolharze eingesetzt werden. Zur Einbettung des leitfähigen Materials in das Duromer ist Ruß mit einer DPB-Absorption von > 300 ml/100 g entsprechend DIN 53601 zweckmäßig. Für den Ruß wird ein Intervall für den pH-Wert von 6-10 entsprechend DIN 53200 vorgegeben. In Abhängigkeit von der zu realisierenden Leitfähigkeit ist eine Zugabe von Ruß mit einem Anteil von 0,1 - 2,0 Gew-% zweckmäßig.

Das Herstellungsverfahren für den Verbundwerkstoff wird derart durchgeführt, daß der Ruß mit dem Harz mit einer Dissolverscheibe ca. eine Stunde lang bei einer Drehzahl von etwa 5.500 U/min. dispergiert wird. Der Ruß wird hierdurch in Teilchen mit einem mittleren Durchmesser von < 1 µm zerteilt. Die durch diesen Verfahrenssschritt entstehende Dispersion wird zur Durchführung eines Agglomerationsvorganges ruhengelassen. Bei einem Rußgehalt von 1 Gew-% hat sich eine Ruhezeit von vier Tagen bei Raumtemperatur als zweckmäßig erwiesen.

Nach der Ruhezeit wird in die Dispersion ein Härter unter Aufwendung geringer Scherkräfte untergerührt. Durch die geringen Scherkräfte wird gewährleistet, daß die gebildeten Agglomerate nicht wieder zerstört werden. Die Durchführung eines Rührvorganges mit geringen Scherkräften kann bei einer verringerten Viskosität des Harzes, wie sie durch eine erhöhte Harztemperatur von beispielsweise 50° C erreicht wird, unter Verwendung eines Magnetlaborrührers durchgeführt werden.

Zur Beschleunigung der Agglomeration ist es möglich, innerhalb der Rußdispersion eine erhöhte Ionenkonzentration vorzusehen. Die Ruhezeit von vier Tagen bei einem Anteil von einem Gew-% Ruß kann hierdurch auf wenige Minuten reduziert werden. Aufgrund einer erhöhten Ionenkonzentration wird darüber hinaus eine Erniedrigung der Perkolationsschwelle von 0,1 bis 2,0 Gew-% und eine Erhöhung der Leitfähigkeit hervorge rufen.

Die oben beschriebene Dispersion aus Ruß und Harz kann als Matrixmaterial für glasfaserverstärkte Kunststoffe verwendet werden. Ein beim Härtungsprozeß entstehender Harzfluß ist derart vorzugeben, daß die durch den Harzfluß erzeugten leichten Scherkräfte die Agglomeration des Rußes unterstützen und nicht beeinträchtigen.

Eine Herstellung des Verbundwerkstoffes kann beispielsweise derart erfolgen, daß als Epoxydharz Araldit LY 556 verwendet wird, das mit einem Härter HY 932 W versetzt wird, der von Ciba Geigy angeboten wird. Als leitfähiges Substrat wird der Hochleitfähigkeitsruß Printex XE2 von Degussa verwendet. Nach der Durchführung des Dispersionsvorganges wird die Dispersion aus Ruß und Epoxydharz bei Raumtemperatur für vier Tage gelagert. Das Epoxydharz wird nach Zugabe des Härters drei Stunden lang bei 80° C und anschließend acht Stunden lang bei 140° C im Ofen ausgehärtet.

Zur Erhöhung der Ionenkonzentration kann eine Zugabe von Kupferchlorid zum aromatischen Aminhärter erfolgen. Die erforderliche Menge an Kupferchlorid wird hierzu in Methanol gelöst und dem Härter zugegeben. Das Methanol wird anschließend im Vakuum oder bei erhöhter Temperatur wieder aus dem Härter entfernt. Bei einer Zugabe von 0,04 Gew-% Kupferchlorid wird die Perkolationsschwelle von 0,5 Gew-% Anteil an Ruß auf 0,1 Gew-% erniedrigt. Unter Perkolationsschwelle wird ein Anstieg der Leitfähigkeit auf über 10⁻⁸ S/cm verstanden.

Ein weiteres Anwendungsbeispiel besteht in der Herstellung von glasfaserverstärktem Epoxydharz. Hierzu werden als Fasern das E-Glasroving K43 von Gewetex verwendet. Die Fasern werden bei einer Temperatur von 25 °C mit dem rußgefüllte Epoxydharz getränkt. Mit einem Faserwickelverfahren wird anschließend ein Vorprodukt (Prepreg) hergestellt. Aus diesem Vorprodukt wird ein Laminat aufgebaut, das im Autoklaven bei einem Druck von 1 bar ausgehärtet wird.

Durch die Zugabe des Rußanteiles zu dem Duromer entsteht keine einheitlich leitfähige Substanz, sondern innerhalb des Duromers werden Leitfähigkeitskanäle ausgebildet. Die Leitfähigkeitskanäle werden durch die Rußagglomerate hervorgerufen, innerhalb derer die Primärteilchen (22) sich auf einen Abstand von unterhalb 10 nm einander angenähert haben. Diese Annäherung führt zu einem Aneinanderhaften der einzelnen Primärteilchen (22). Zur Realisierung der Leitfähigkeit ist es erforderlich, daß das entstehende Agglomerat (25) eine Dimension erreicht, die der Abmessung der Probe entspricht. Hierdurch wird die Perkolationsschwelle überschritten.

Die Durchführung der Agglomeration ist ein Verfahrensschritt, der zeitabhängig ist. Eine Beschleunigung des Verfahrens ist durch eine abnehmende Viskosität des Harzes, eine zunehmende Teilchenkonzentration und eine lediglich leichte Scherung des Duromers hervorzurufen.

Eine Verlangsamung des Agglomerationsvorganges wird durch elektrostatische Aufladungen der Rußteilchen hervorgerufen. Durch Zusatz von salzartigen Stoffen, die die Ionenkonzentration erhöhen, beispielsweise durch den Zusatz von Kupferchlorid, wird die Aufladung der Rußteilchen geändert. Die besonders niedrige Perkolationsschwelle von weniger als 0,5 Gew-% Ruß beziehungsweise von weniger als 0,1 Gew-% Ruß wird durch die Ausbildung eines offenen Rußnetzes hervorgerufen. Das Rußnetzwerk besteht aus den Primärteilchen (22) mit einem Durchmesser von etwa 30 nm, den Aggregaten (23) mit einem Durchmesser von weniger als 1 µm und den aus den Aggregaten (23) gebildeten Agglomeraten (25), die im Endzustand eine Dimension aufweisen, die sich über den Gesamtbereich der Probe erstreckt.

Durch die Ausbildung eines offenen Rußnetzwerkes wird erreicht, daß umschlossene rußfreie Bereiche möglichst groß sind. Dies wird insbesondere auch dadurch unterstützt, daß hohle Primärteilchen (22) verwendet werden, bei denen der Kohlenstoff entsprechend einer Hohlkugel angeordnet ist. Zur Kennzeichnung des hierdurch entstehenden Leervolumens der Aggregate (23) dient die DBP-Absorption, die für Standardruß bei etwa 100 ml/100 g liegt. Bei dem eingesetzten Hochleitfähigkeitsruß Printex XE2 beträgt der Wert für die DBP-Absorption 380 ml/100 g Ruß.

Ein wesentlicher Verfahrensschritt für die Ausbildung der offenen Struktur der Agglomerate (25) besteht in einer sorgfältigen Durchführung des Dispersionsvorganges. Hierdurch wird eine Zerteilung der Rußelemente in Teilchen mit einem Durchmesser von weniger als 1 µm gewährleistet. Diese starke Zerteilung ist deshalb zweckmäßig, da die zunächst vorhandenen Rußperlen kompakter sind als die Rußagglomerate. Somit ist die räumliche Ausdehnung der Rußperlen geringer, was eine geringere räumliche Ausdehnung des leitfähig modifizierten Harzvolumens zur Folge hat.

Während der Durchführung der Ruhezeit nach dem Dispersionsvorgang agglomerieren die Rußteilchen aufgrund des physikalischen Prinzips der Brown'schen Bewegung. Die auftretenden Zeitkonstanten hängen von der Viskosität des Harzes, der Temperatur, den Teilchendurchmessern , der Konzentration des Rußes und von auftretenden Wechselwirkungen ab. An Wechselwirkungen sind insbesondere Dispersionskräfte und elektrostatische Kräfte zwischen den Rußteilchen und dem Harz sowie zwischen den Rußteilchen untereinander zu berücksichtigen. Mit zunehmender Größe der Agglomerate (25) nimmt die Brown'sche Bewegung der Agglomerate (25) ab und es wird ein Gleichgewichtszustand erreicht, der eine weitere Zunahme der Agglomeration unterbindet. Zur Weiterführung des Agglomerationsprozesses nach Erreichen dieses Gleichgewichtszustandes ist eine leichte Scherung der Dispersion notwendig, da durch diese Bewegung die Kollisionsrate der Agglomerate erhöht und damit der Agglomerationsvorgang wieder in Gang gesetzt wird. Die leichte Scherung kann durch einen Fluß des Harzes hervorgerufen werden.

Zur Ermöglichung der Agglomeration des Rußes in einem glasfasergefüllten Duromer sind ebenfalls Scherkräfte erforderlich, die durch den Harzfluß während des Härtungsprozesses entstehen.

Durch die Kombination des Duromers mit einem elektrisch leitfähigen Füllmaterial, insbesondere mit Ruß, werden dem Verbundwerkstoff elektrisch leitfähige Eigenschaften verliehen, ohne eine ungünstige Veränderung der mechanischen Kenndaten hervorzurufen. Dies wird durch die Gegenüberstellung der physikalischen Daten in den Figuren 6 bis 8 dokumentiert.

Die Ionenkonzentration im Epoxydharz kann auch durch Zugabe von Kupferchlorid zum aromatischen Aminhärter erfolgen.

## Patentansprüche

1. Verbundwerkstoff aus Kunststoff, der mindestens teilweise aus einem faserverstärkten Duromer ausgebildet ist und der mit einem elektrisch leitfähigen Substrat kombiniert ist und bei dem das Duromer als polymere Matrixanordnung ausgebildet ist, in die die elektrisch leitfähige Substanz als Füllstoff eingebettet ist und bei dem der Füllstoff aus Ruß ausgebildet ist, dadurch gekennzeichnet, daß ein Anteil des Füllstoffes von 0,1 - 2,0 Gew-% vorgesehen ist, daß der Füllstoff feindispers mit einer Teilchengröße < 30 µm eingebracht ist und daß zur Erhöhung der Ionenkonzentration ein Salz enthalten ist.

2. Verbundwerkstoff nach Anspruch 1, dadurch gekennzeichnet, daß die Faserverstärkung aus Glasfasern ausgebildet ist.

3. Verbundwerkstoff nach Anspruch 1 oder 2 dadurch gekennzeichnet, daß die Faserverstärkung aus Aramidfasern ausgebildet ist.

4. Verfahren zur Herstellung eines Verbundstoffes aus Kunststoff, der mindestens teilweise aus einem faserverstärkten Duromer ausgebildet ist und der mit einer elektrisch leitfähigen Substanz kombiniert wird und bei dem das Duromer mit einer polymeren Matrixstruktur ausgebildet wird und in die Matrixstruktur die elektrisch leitfähige Substanz als Füllstoff eingebettet wird und bei dem als Füllstoff Ruß eingebettet wird, dadurch gekennzeichnet, daß der Füllstoff feindispers mit einer Teilchengröße < 30 µm eingebettet wird, daß der feindisperse Füllstoff mit einem Anteil von etwa 0,1 - 2,0 Gew-% eingebettet wird und daß die Ionenkonzentration in der Dispersion durch Zugabe eines Salzes erhöht wird

5. Verfahren nach Anspruch 4, dadurch gekennzeichnet, daß der Füllstoff für etwa eine Stunde bei einer Mischerdrehzahl von 5.500 U/min in ein zur Ausbildung des Duromers vorgesehenes Harz dispergiert wird.

6. Verfahren nach Anspruch 4 oder 5, dadurch gekennzeichnet, daß der Dispergierungsvorgang solange durchgeführt wird, bis eine Teilchengröße des Füllstoffes von höchstens 1 µm erreicht ist.

7. Verfahren nach einem der Ansprüche 4 bis 6, dadurch gekennzeichnet, daß nach der Durchführung des Dispergierungsvorganges eine Ruhephase von zwei bis sechs Tagen vorgesehen ist.

8. Verfahren nach einem der Ansprüche 4 bis 7, dadurch gekennzeichnet, daß die Ruhephase bei Raumtemperatur durchgeführt wird.

9. Verfahren nach einem der Ansprüche 4 bis 8, dadurch gekennzeichnet, daß ein Einrühren eines Härters in die aus dem Harz und dem Füllstoff gebildete Dispersion bei einer Temperatur von etwa 50° C durchgeführt wird.

10. Verfahren nach einem der Ansprüche 4 bis 9, dadurch gekennzeichnet, daß Kupferchlorid als Salz zugegeben wird.

11. Verfahren nach einem der Ansprüche 4 bis 10, dadurch gekennzeichnet, daß Kupferchlorid in einer Menge von 0,001 - 0,10 Gew-% zugegeben wird.
